# EUROPEAN PATENT SPECIFICATION

(11) **EP 0 284 199 B1**
(45) Date of publication and mention of the grant of the patent: **15.12.1993**
(21) Application number: 88301452.4
(22) Date of filing: 19.02.1988
(51) Int. Cl.: G06F 15/60

(54) **Gate processor arrangement for simulation processor system**
Torverarbeitungsanordnung zum Simulationsverarbeitungssystem
Agencement à processeur de portes pour systèmes de processeur de simulation

(30) Priority: 20.02.1987 JP 37318/87
(43) Date of publication of application: 28.09.1988
(73) Proprietor: FUJITSU LIMITED, Kawasaki-shi, Kanagawa 211 (JP)
(72) Inventor: Hirose, Fumiyasu, Machida-shi Tokyo 194 (JP)
(74) Representative: Billington, Lawrence Emlyn

(56) References cited:
- EP-A- 0 096 176
- CONFERENCE PROCEEDINGS OF THE 9TH ANNUAL SYMPOSIUM ON COMPUTER ARCHITECTURE, Austin, Texas, 26th-29th April 1982, pages 148-157, IEEE, US; M. ABRAMOVICI et al.: "A logic simulation machine"
- IEEE INTERNATIONAL CONFERENCE ON COMPUTER-AIDED DESIGN, Santa Clara, CA, US, 9th-12th November 1987, pages 484-487; HIROSE et al.: "Simulation Processor SP"

## Description

The present invention relates to a gate processor arrangement for a simulation processor (SP) system, such as a simulation processor system constituted by a control processor, input and output processors, and an event transmission arrangement which is used for the logic verification of very large scale integrated circuits (VLSI's) before production.

In general, in the operation of a gate processor, it is necessary to carry out evaluation processes for evaluating the data of gates in the logic network to be verified, and to carry out inter-processor transmission for transmitting data between gate processors corresponding to sections of the logic network to be verified.

In a previously-proposed gate processor, when a plurality of input data to a gate is simultaneously changed, the evaluations of the same gate are duplicated and such duplicated evaluations reduce the efficiency of the system.

Also, in such duplicated evaluations, a pseudo event may occur which will cause a problem in that additional devices and processes are required to deal with such a pseudo event.

In addition, when a plurality of fanouts of a border gate in a logic network section corresponding to a gate processor exist in another logic network section corresponding to another gate processor, a plurality of data transmissions must be carried out even if this plurality of destination gates are included in the same another gate processor. This causes a problem in that such a plurality of data transmissions will reduce the efficiency of the system.

Also, when the data transmission between gate processors occur frequently in a particular later period in one step of the processing, the speed of the processing in the gate processor in question is reduced, causing a delay in the processing. This causes a problem in that such a delay also reduces the efficiency of the system.

Furthermore, it is necessary to make a double access, i.e. reading and writing, to a net status memory in a gate processor in one machine cycle. This limits the speed of the operation and thus reduces the efficiency of the system.

Accordingly, it is desirable to provide a gate processor arrangement for a logic simulation processor system which can avoid the above-described problems.

An article in IEEE Design and Test, August 1984, pages 21 to 39, by T. Blank, entitled "A Survey of Hardware Accelerators used in Computer-aided Design", describes various types of simulation processor, including hardware logic simulators by NEC ("HAL"), Zycad and Dais Systems ("Megalogician"), corresponding to the prior art referred to above.

A paper in Conference Proceedings of the 9th Annual Symposium on Computer Architecture, Austin, Texas, U.S.A., April 1982, by M. Abramovici et al., entitled "A Logic Simulation Machine", describes a simulation processor having the features of the preamble of accompanying claim 1. In this simulation processor, multiple changes to the inputs of the same gate are dealt with by a two-pass strategy of first compiling an "evaluation list" of elements to be evaluated, and then performing the actual evaluation.

According to the present invention, there is provided a gate processor for a logic simulation processor system including a control processor, input and output processors, and an event transmission network, said gate processor comprising:-
a new event buffer memory for storing an event at a timing "t" for a predetermined logic element in a section of a logic network;
a fanout device for holding connection information for said predetermined logic element and reading the data thereof precedingly at a timing "t", the input data of said predetermined logic element being changed at a timing "t+1";
a net status memory for holding net status information corresponding to input data and output data of a predetermined logic element; and
an evaluation device operable to read the data in said net status memory, to generate information for a change of the network status at a timing "t+1", and to supply said generated information to the event transmission network and/or said new event buffer memory;
characterised in that said net status memory is arranged to receive said information from the new event buffer memory at the beginning of each operation cycle, and to supply said information to said evaluation device without receiving data therefrom;
and in that an evaluation gate buffer memory is provided, having a plurality of evaluation gate memory portions each able to be connected with said fanout device or said evaluation device, wherein input data of a predetermined logic element which is changed at the timing "t" is supplied from one of the evaluation gate memory portions to the evaluation device, while input data of a predetermined logic element which is changed at the timing "t+1" is received by another of the evaluation gate memory portions.

Reference will now be made, by way of example, to the accompanying drawings, in which:
Fig. 1 shows an example of a separation into sections of a logic network for which a logic simulation by a simulation processor system using a gate processor arrangement is to be used;
Fig. 2 shows an example of operations of the logic elements in the logic network of Fig. 1;
Fig. 3 shows a logic simulation processor system to which a gate processor arrangement embodying the present invention can be applied;
Fig. 4 shows a prior art gate processor;
Fig. 5 shows a gate processor system for a logic simulation processor system embodying the present invention;
Fig. 6 shows the structure of the net status memory in the gate processor system of Fig. 5;
Fig. 7 shows an example of arrangement of logic elements for explaining the operation of the net status memory of Fig. 6;
Fig. 8 shows an example of operation of the net status memory of Fig. 6; and
Fig. 9 illustrates an example of the operation of the gate processor system embodying the present invention.

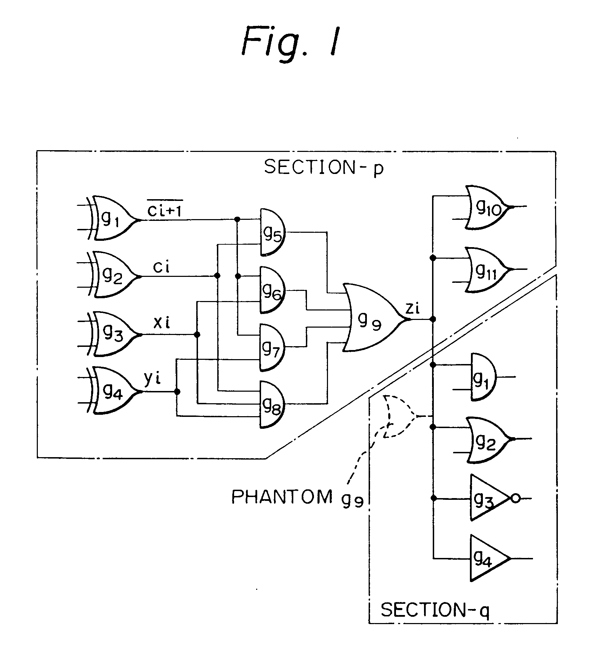

Before describing an embodiment of the present invention, a previously-proposed arrangement and operation will be described with reference to Fig. 1, Fig. 2, Fig. 3, and Fig. 4.

An example of a separation into sections of a logic network in a very large scale integrated circuit (VLSI) to which a logic simulation by a simulation processor system using a gate processor arrangement is to be used is shown in Fig. 1. The logic network in a VLSI shown in Fig. 1 is verified by a simulation processor system using a gate processor arrangement.

The logic network is divided into, for example, a section-p and a section-q, as shown in Fig. 1. Section-p includes exclusive OR gates g₁ , g₂ , g₃ , and g₄ , AND gates g₅ , g₆ , g₇ , and g₈ , an OR gate g₉ , and OR gates g₁₀ , and g₁₁ , and section-q includes an AND gate g₁ , an OR gate g₂ , a NOT gate g₃ , and a buffer g₄. In section-p, gate g₉ is considered to be a border gate. In section-q, a phantom g₉ gate can be presumed as shown by a broken line. The data Zi from gate g₉ in section-p is to be transmitted to several gates in section-q. The exclusive OR gate g₁ , g₂ , g₃ , and g₄ deliver carry data C̅ᵢ̅₊̅₁̅ and Cᵢ , and input data xᵢ and yᵢ , respectively.

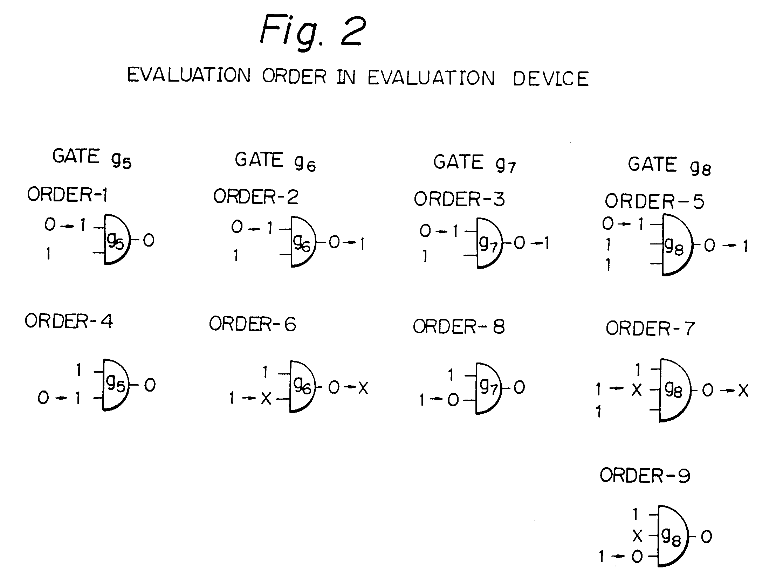

As an explanation of the evaluation process, an example of changes of the input/output data of the gates g₅ to g₈ in section-p of the network shown in Fig. 1 is illustrated in Fig. 2, ORDER-1 to ORDER-9 indicate the order in which data of the gates passes through the evaluation device in the gate processor.

In Fig. 2, it can be seen that, when a plurality of inputs to a gate are changed, duplicate evaluations must be carried out for a single gate. Also, it can be seen that, in ORDER-5, ORDER-7, and ORDER-8 of gate g₈ , the output of gate g₈ is consequently not changed due to a sequence of changes of the input data, but in the intermediate ORDER-5 and ORDER-7, the output data is changed, and thus pseudo events occur.

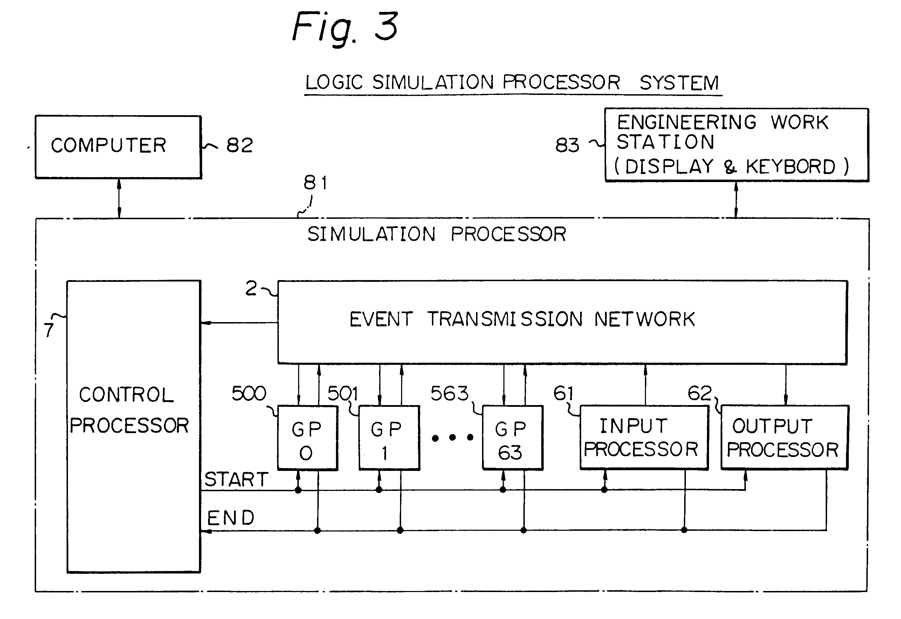

A logic simulation processor system to which a gate processor arrangement is applied is shown in Fig. 3. The logic simulation processor system is constructed from a simulation processor 81, a computer 82, and an engineering work station (display and keyboard). The simulation processor includes a control processor 7, an event transmission network 2, gate processors 500, 501, ... 563, an input processor 61, and an output processor 62. The gate processors 500, 501, ... 563 correspond to sections of the logic network, respectively. The structure and operation of the event transmission network is explained in detail, for example, in Japanese Patent Application Nos. 62-4522 and 62-4523 filed January 12, 1987 and in the corresponding EP-A-0 275 176.

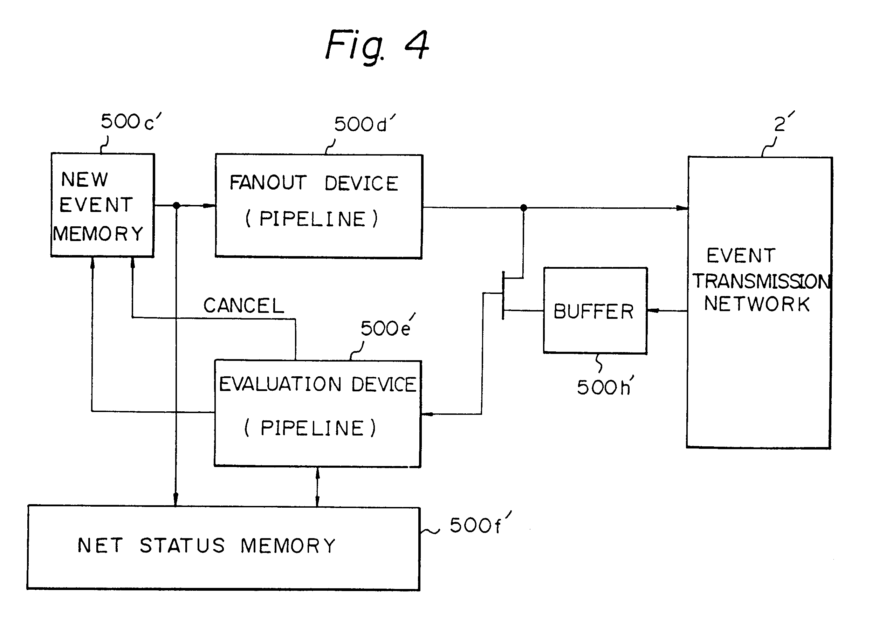

An example of the prior art gate processor is shown in Fig. 4. The gate processor of Fig. 4 is constituted by an event transmission network 2', a buffer 500h', a new event memory 500c', a fanout device 500d' in the form of pipeline, an evaluation device 500e' in the form of pipeline, and a net status memory 500f'.

In the gate processor of Fig. 4, the net status memory 500f' stores the information of the statuses of the gates as logic units in the section of the logic network corresponding to the present gate processor. The new event memory 500c' stores the event information for the gate having an output which is changed at a timing t, based on the result of an evaluation carried out in the evaluation device 500e' at a timing "t-1". The buffer 500h' holds the information received from other gate processors. The fanout device 500d' holds the information of the which gate input is changed in correspondence with the change of an event supplied from the new event memory 500c', on the basis of held information on the connection of the gates in the section of the logic network. The evaluation device 500e' receives the information on the gate which has undergone an input change as extracted by the fanout device 500d', receives information on the desired gate from the net status memory 500f', and decides the output value of the gate which has undergone an input change. The decided output value is supplied to the new event memory 500c'.

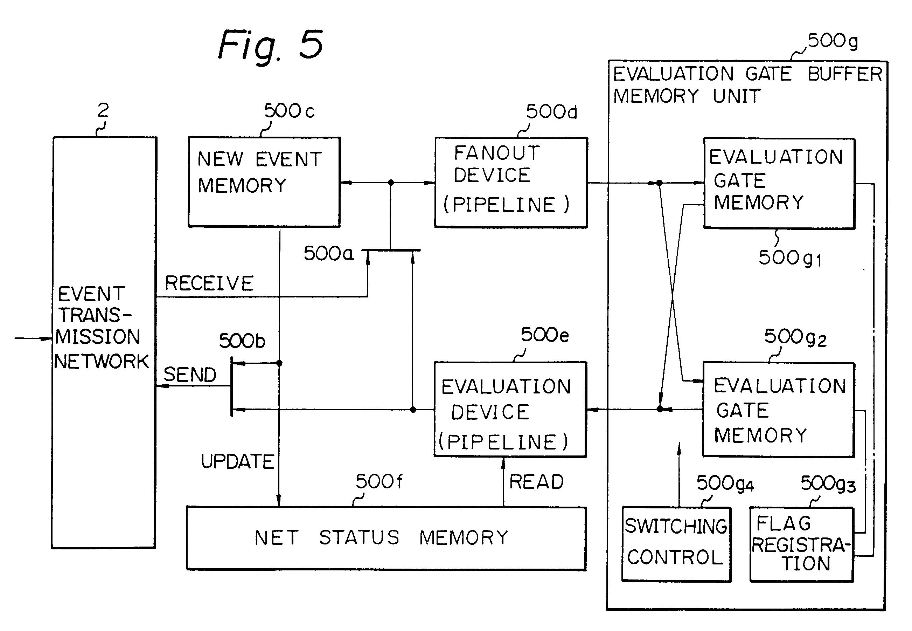

A gate processor system for a logic simulation processor system embodying the present invention is shown in Fig. 5. In Fig. 5, a single gate processor in a gate processor system is shown.

The gate processor of Fig. 5 includes OR gates 500a and 500b, a new event memory 500c, a fanout device (pipeline type) 500d, an evaluation device (pipeline type) 500e, a net status memory 500f, and an evaluation gate buffer memory unit 500g. The evaluation gate buffer memory unit 500g includes evaluation gate memories 500g₁ and 500g₂. An event transmission network 2 is provided as an inter-processor transmission means. The output of the evaluation device 500e is supplied through the OR gate 500b to the event transmission network 2.

The connections between the fanout device 500d and the evaluation device 500e, and the evaluation gate memories 500g₁ and 500g₂ in the evaluation gate buffer memory unit 500g are changed by a switching control device 500g₄. A flag registration device 500g₃ operates in association with evaluation gate memories 500g₁ and 500g₂.

The evaluation gate memories 500g₁ and 500g₂ operate as follows. At a timing t, the data of a gate having an input which is changed at a timing "t+1" from the fanout device 500d is received by the evaluation gate memory 500g₁ , and the data of a gate having the input which is changed at a timing t is supplied from the evaluation gate memory 500g₂ to the evaluation device 500e.

At the next timing "t+1", the connections between the fanout device 500d and the evaluation device 500e, and the evaluation gate memories 500g₁ and 500g₂ are switched, the data of a gate having an input which is changed at a timing "t+1" is supplied from the evaluation gate memory 500g₁ to the evaluation device 500e, and the data of a gate having an input which is changed at a timing "t+2" from the fanout device 500d is received by the evaluation gate memory 500g₂ , which becomes vacant in the preceding timing.

In each of the evaluation gate memories 500g₁ and 500g₂ , when the data in question is the data of a border gate or internal/border gates, the storing is carried out from the maximum address of the evaluation gate memory, and when the data in question is the data of an internal gate only, the storing is carried out from the minimum address of the evaluation gate memory, and thus, the classification of the gates and the storage of the data of such classified gates into the evaluation gate memory are carried out.

When a data is stored to an address of the evaluation gate memory corresponding to the gate in question, a flag is registered to this address so that further data cannot be stored to this address, and accordingly, a duplicate evaluation will not occur. Where the data of gates stored in the evaluation gate memory is read, the corresponding flag is changed to 0 so that all of the flags are cleared when the reading is terminated.

The net status memory 500f is updated at the beginning of the operation period, and the evaluation device 500e reads only the input and output data of the gates. The evaluation device 500e is constructed to make a simultaneous access to the output of the gate and to the input of the gate.

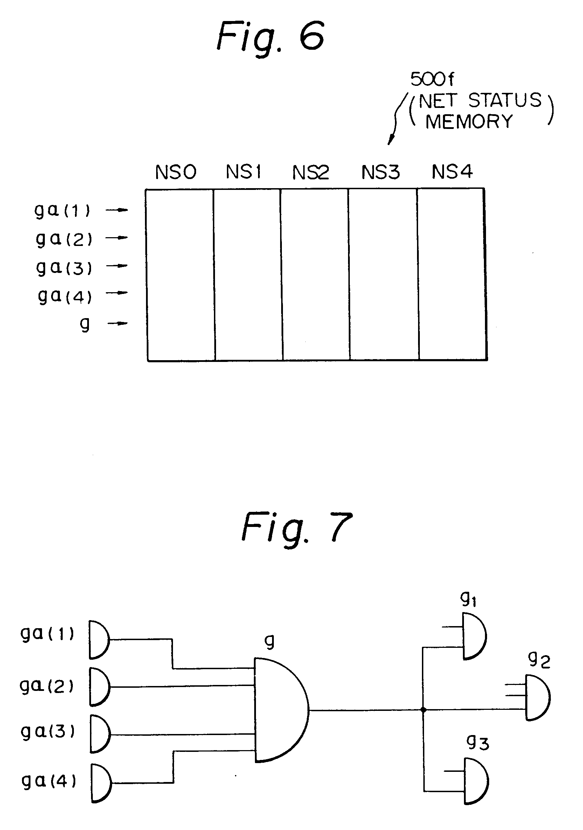

An example of the structure of the net status memory 500f in Fig. 5 is shown in Fig. 6. The net status memory is constituted by the memory divisions NS0, NS1, NS2, NS3, and NS4 having the same memory content. The content of the memory divisions NS0, NS1, ... NS4 can be read by the identifications gₐ(1), gₐ(2), gₐ(3), gₐ(4), and g of the gates.

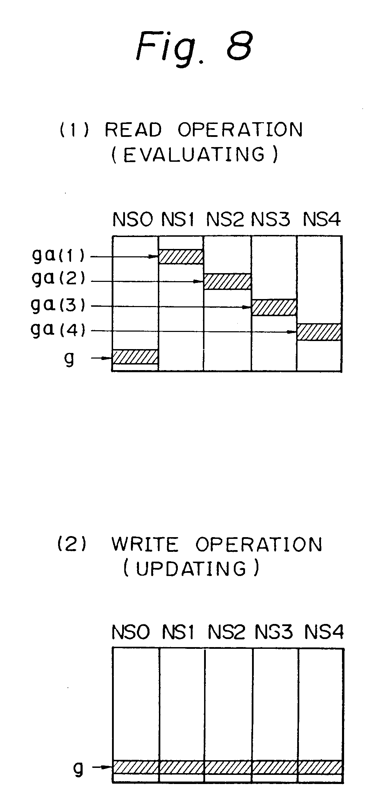

An example of the arrangement of gates to be treated is shown in Fig. 7. The operation of the net status memory 500f with respect to the arrangement of Fig. 7 is illustrated in Fig. 8. In the read operation, the accesses are carried out simultaneously by different addresses to read data. In the write operation, i.e., update operation, only a single address need be updated. In the operation illustrated in Fig. 8, either a read operation or a write operation is carried out in one operation cycle.

An example of the operation of the gate processor system embodying the present invention will be described. It is presumed that a first of the gate processors is assigned to section-p of the network of Fig. 1 and another of the gate processors is assigned to section-q of the network of Fig. 1.

The data of the gate having inputs which are changed at a timing "t-1" is evaluated by the evaluation device 500e of the first gate processor.

As a result, the changes of the data of 0 to 1 in gate g₁ , 0 to 1 in gate g₂ , 1 to X in gate g₃ , and 1 to 0 in gate g₄ are acknowledged. X represents an unknown data which cannot be decided to be either 0 or 1. These changes are stored in the new event memory 500c and supplied to the fanout device 500d. The data of gates having input signals changed at a timing t are delivered from the fanout device 500d and registered in the evaluation gate buffer memory unit 500g.

It is presumed that the evaluation gate memory 500g₁ is connected with the evaluation device 500e and the evaluation gate memory 500g₂ is connected with the fanout device 500d. The data sequence: i.e., g₅ data, g₆ data, g₇ data, g₅ data, g₈ data, g₆ data, g₈ data, g₇ data, and g₈ data, is forwarded to the evaluation gate memory. In this sequence, the data sequence: i.e., g₅ data, g₆ data, g₇ data, g₈ data is stored in the evaluation gate memory 500g₂ , but the second data: i.e., the second g₅ data, the second g₆ data, the second g₈ data, the second g₇ data, and the second g₈ data is not stored in the evaluation gate memory 500g₂ , due to the prevention of a duplicate registration.

When the processing of the evaluation device 500e for all of the gate processors and the transmission are terminated, the timing becomes the timing t. The fanout device 500d may be still in operation at the timing t.

At the timing t, the net status memory 500f is updated by the new event memory 500c.

If the event observation flag is established for any of the gates g₁ to g₄ , the gate number data, the gate processor number data p (of the gate processor in question), the event observation flag ON data, and the new/old values are transmitted from the new event memory 500c to outside of the gate processor and be supplied to the event observation processor.

The observation flag for the gate event is held locally in the evaluation device 500e, and thus, the data 0, 0, 1, and 1 of the gates g₁ , g₂ , g₃ , and g₄ are updated to 1, 1, X, and 0.

When the updating and the fanout operation are terminated, and when the g₅ data, g₆ data, g₇ data, and g₈ data are registered in the evaluation gate memory 500g₂ , the switching between the evaluation gate memory 500g₁ and the evaluation gate memory 500g₂ takes place, and the evaluation gate memory 500g₂ supplies the g₅ data, g₆ data, g₇ data, and g₈ data to the evaluation device 500e. The data of a gate stored in the evaluation gate buffer memory unit 500g covers the gate number, the processor number, and the transmission mode. The transmission mode represents one of the internal gate mode, the border gate mode, and the internal/border gate mode. Where the mode of the border gate is valid, the processor number represents the transmission destination processor number. In the above-described operations, all of the gates g₅ to g₈ are internal gates, and thus the preceding processing for the border gates does not occur.

In the evaluation operation, it is acknowledged that the change of 0 to 1 of the g₅ data and the change of 0 to X of the g₆ data take place at a timing "t+1". These changes are registered in the new event memory 500c, and the fanout device 500d then registers the g₉ data in the evaluation gate memory 500g₁.

In this case, the transmission mode for gage g₉ is the internal/border gate mode, and the processor number is q. If there are n destination processors q₁ , q₂ , ... qₙ , the g₉ data is delivered n times from the fanout device 500d, but only at the first delivery is the mode the internal/border gate mode and the processor number q₁. In the second to the n-th times, the mode is the border gate mode, and the processor number is qᵢ , where i is 2, 3, ... n.

According to the duplicate registration prevention arrangement, where the arrangement for gate g₁ is registered, the arrangement for gates g₂ to gₙ is also registered. When gate g₁ is excluded by the duplicate registration prevention function, the gates g₂ to gₙ are also excluded by the duplicated registration prevention function.

When the evaluation of all of the gate processors and the transmission are terminated, the time becomes the timing "t+1". At the timing "t+1", the g₅ data and g₆ data are updated from 0 and 0 to 1 and X.

After the updating and the fanout operation are terminated, the switching between the evaluation gate memory 500g₁ and the evaluation gate memory 500g₂ takes place, and the g₉ data is supplied to the evaluation device 500e. This is because the mode is the internal/border gate mode.

Even if there are data of many of the other internal gates registered in the evaluation gate buffer memory unit 500g, the g₉ data is first read and processed. When the change of g₉ data from 0 to 1 is acknowledged, the evaluation device 500e registers the change in the g₉ data in the new event memory 500c, sends a request to the fanout device 500d, and carries out a transmission to the outside. If the mode is the border gate mode, only a transmission to the outside takes place.

Where a transmission to the gate processor for section-p exists, the data is registered in the new event memory 500c and a request for a read by the fanout device is carried out when the evaluation device 500e does not cause a registration to the new event memory 500c, that is, except when an event occurs in the internal gate mode or the internal/border gate mode.

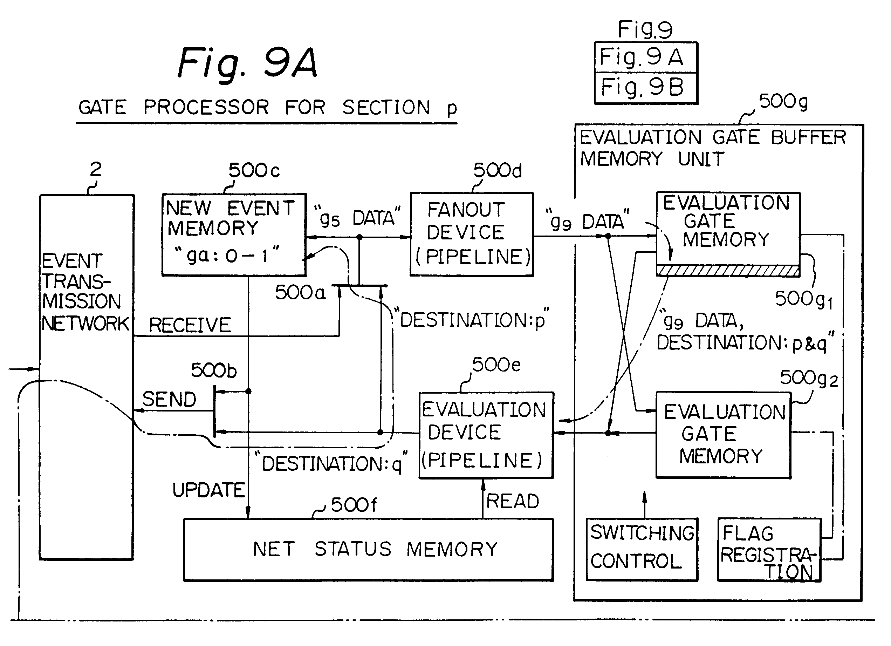

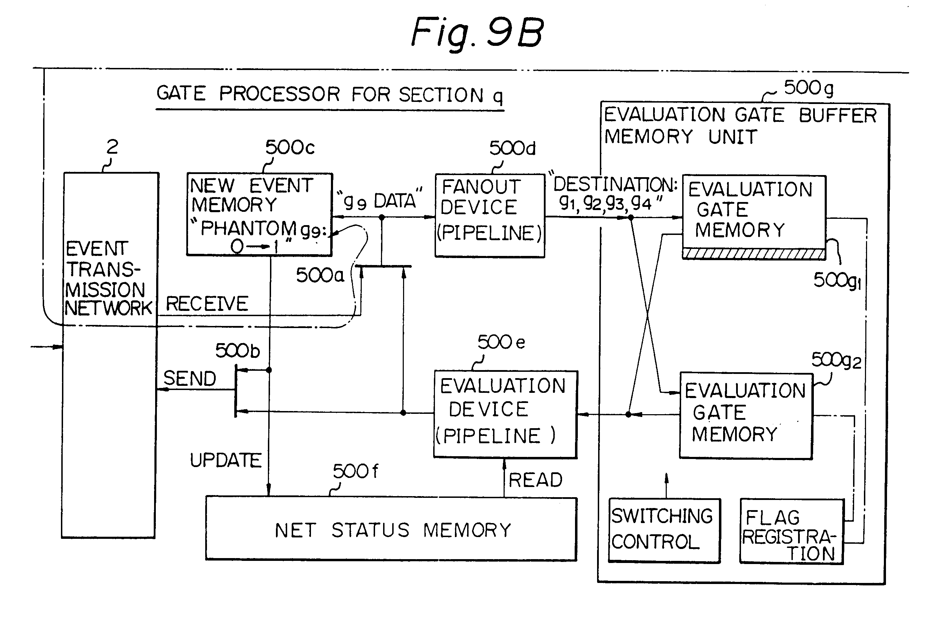

An example of the operation of the gate processor system, including the gate processor for the logic network section-p and the gate processor for the logic network section-q, embodying the present invention is illustrated in Fig. 9.

First, g₅ data, is supplied to the fanout device 500d of the present gate processor for section-p. The fanout device 500d delivers the information g₉. The data g₉ has two destinations: section-p and section-q. The information g₉ is stored in the maximum address side of the evaluation gate memory 500g₁.

The g₉ data with the destinations section-p and section-q is supplied to the evaluation device 500e. The g₉ data with the destination section-p is supplied from the evaluation device 500e through the OR gate 500a to the new event memory 500c. Accordingly, the change from 0 to 1 of the g₉ data is stored in the new event memory 500c. The g₉ data with the destination section-q is supplied from the evaluation device 500e through the OR gate 500b, and the event transmission network 2 to the other gate processor for section-q.

In the other gate processor for section-q, the g₉ data with the destination section-q sent from the present gate processor is supplied through the event transmission network 2 and the OR gate 500a to the new event memory 500c. Accordingly, the change from 0 to 1 of a phantom gate g₉ is stored in the new event memory 500c. The g₉ data is also supplied to the fanout device 500d, which delivers an output representing "destination: g₁ , g₂ , g₃ , and g₄".

## Claims

1. A gate processor (500) for a logic simulation processor system including a control processor (7), input and output processors (61, 62), and an event transmission network (2), said gate processor comprising:-
a new event buffer memory (500_{c}) for storing an event at a timing "t" for a predetermined logic element in a section of a logic network;
a fanout device (500_{d}) for holding connection information for said predetermined logic element and reading the data thereof precedingly at a timing "t", the input data of said predetermined logic element being changed at a timing "t+1";
a net status memory (500_{f}) for holding net status information corresponding to input data and output data of a predetermined logic element; and
an evaluation device (500ₑ) operable to read the data in said net status memory (500_{f}), to generate information for a change of the network status at a timing "t+1", and to supply said generated information to the event transmission network (2) and/or said new event buffer memory (500_{c});
characterised in that said net status memory (500_{f}) is arranged to receive said information from the new event buffer memory (500_{c}) at the beginning of each operation cycle, and to supply said information to said evaluation device (500ₑ) without receiving data therefrom;
and in that an evaluation gate buffer memory (500_{g}) is provided, having a plurality of evaluation gate memory portions (500_{g1}, 500_{g2}) each able to be connected with said fanout device (500_{d}) or said evaluation device (500ₑ), wherein input data of a predetermined logic element which is changed at the timing "t" is supplied from one of the evaluation gate memory portions (500_{g1}, 500_{g2}) to the evaluation device (500ₑ), while input data of a predetermined logic element which is changed at the timing "t+1" is received by another of the evaluation gate memory portions (500_{g1}, 500_{g2}).

2. A gate processor according to claim 1, wherein said evaluation gate buffer memory (500_{g}) further comprises a flag registration means (500_{g3}) operable to register a flag in an address of one of the evaluation gate memory portions corresponding to a predetermined logic element to which data has just been stored, whereby the evaluation gate buffer memory (500_{g}) is able to hold information from the fanout device (500_{d}) without duplicate storage of data for any predetermined logic element to which a plurality of changed input signals are supplied in the same operation cycle.

3. A gate processor according to claim 1 or 2, wherein in each section of the logic network to be simulated, the logic elements are categorised as "internal" elements having no effect on other sections of the network, or as "border" or "internal/border" elements having an effect on at least one other section of the network, and wherein when the evaluation gate buffer memory (500_{g}) receives information for a predetermined logic element from the fanout device (500_{d}), if the information relates to a border or internal/border element, that information is stored from the maximum address of the connected evaluation gate memory portion, and if the information relates to an internal element only, it is stored from the minimum address of said connected memory portion, whereby the evaluation gate buffer memory is able to deliver information for border and internal/border elements prior to information for internal element.

## Patentansprüche

1. Ein Gatterprozessor (500) für ein Logiksimulationsprozessorsystem, das einen Steuerprozessor (7), Eingangs- und Ausgangsprozessoren (61, 62) und ein Ereignisübertragungsnetz (2) enthält, welcher Gatterprozessor umfaßt:-
einen Pufferspeicher für neue Ereignisse (500_{c}) zum Speichern eines Ereignisses zu einer Zeitlage "t" für ein vorbestimmtes Logikelement in einer Sektion eines Logiknetzes;
eine Ausgangsfächerungsanordnung (500_{d}) zum Halten von Verbindungsinformationen für das genannte vorbestimmte Logikelement und zum vorhergehenden Lesen der Daten davon zu einer Zeitlage "t", wobei die Eingangsdaten des genannten vorbestimmten Logikelementes zu einer Zeitlage "t+1" verändert werden;
einen Netzstatusspeicher (500_{f}) zum Halten von Netzstatusinformationen, die Eingangsdaten und Ausgangsdaten eines vorbestimmten Logikelementes entsprechen; und
eine Bewertungsanordnung (500_{c}), die betriebsfähig ist, um die Daten in dem genannten Netzstatusspeicher (500_{f}) zu lesen, um Informationen für eine Veränderung des Netzstatus zu einer Zeitlage "t+1" zu erzeugen, und um die genannten erzeugten Informationen dem Ereignisübertragungsnetz (2) und/oder dem genannten Pufferspeicher für neue Ereignisse (500_{c}) zuzuführen;
dadurch gekennzeichnet, daß der genannte Netzstatusspeicher (500_{f}) angeordnet ist, um die genannten Informationen von dem Pufferspeicher für neue Ereignisse (500_{c}) zu Beginn jedes Operationszyklus zu empfangen, und die genannten Informationen der genannten Bewertungsanordnung (500_{c}) zuzuführen, ohne Daten von ihr zu empfangen;
und daß ein Bewertungsgatterpufferspeicher (500_{g}) vorgesehen ist, der eine Vielzahl von Bewertungsgatterspeicherabschnitten (500_{g1}, 500_{g2}) hat, wovon jeder mit der genannten Ausgangsfächerungsanordnung (500_{d}) oder der genannten Bewertungsanordnung (500_{c}) verbunden werden kann, bei dem Eingangsdaten eines vorbestimmten Logikelementes, die zu der Zeitlage "t" verändert werden, von einem der Bewertungsgatterspeicherabschnitte (500_{g1,} 500_{g2}) der Bewertungsanordnung (500_{c}) zugeführt werden, während Eingangsdaten eines vorbestimmten Logikelementes, die zu der Zeitlage "t+1" verändert werden, durch einen anderen der Bewertungsgatterspeicherabschnitte (500_{g1}, 500_{g2}) empfangen werden.

2. Ein Gatterprozessor nach Anspruch 1, bei dem der genannte Bewertungsgatterpufferspeicher (500_{g}) ferner ein Kennzeichenregistrierungsmittel (500_{g3}) umfaßt, das betriebsfähig ist, um ein Kennzeichen in einer Adresse von einem der Bewertungsgatterspeicherabschnitte, das einem vorbestimmten Logikelement entspricht, für das Daten gerade gespeichert worden sind, zu registrieren, wodurch der Bewertungsgatterpufferspeicher (500_{g}) in der Lage ist, Informationen von der Ausgangsfächerungsanordnung (500_{d}) zu halten, ohne Doppelspeicherung von Daten für irgendein vorbestimmtes Logikelement, dem eine Vielzahl von veränderten Eingangssignalen in demselben Operationszyklus zugeführt werden.

3. Ein Gatterprozessor nach Anspruch 1 oder 2, bei dem in jeder Sektion des Logiknetzes, das zu simulieren ist, die Logikelemente als "interne" Elemente klassifiziert sind, die keine Wirkung auf andere Sektionen des Netzes haben, oder als "Grenz-" oder "interne/Grenz-" Elemente, die eine Wirkung auf wenigstens eine andere Sektion des Netzes haben, und bei dem, wenn der Bewertungsgatterpufferspeicher (500_{g}) Informationen für ein vorbestimmtes Logikelement von der Ausgangsfächerungsanordnung (500_{d}) empfängt, falls sich die Informationen auf ein Grenz- oder internes/Grenzelement beziehen, jene Informationen von der maximalen Adresse des verbundenen Bewertungsgatterspeicherabschnittes gespeichert werden, und falls sich die Informationen nur auf ein internes Element beziehen, sie von der minimalen Adresse des genannten verbundenen Speicherabschnittes gespeichert werden, wodurch der Bewertungsgatterpufferspeicher in der Lage ist, Informationen für Grenz- und interne/Grenzelemente vor Informationen für ein internes Element zu liefern.

## Revendications

1. Processeur de portes (500) pour système de processeur de simulation logique incluant un processeur de commande (7), des processeurs d'entrée et de sortie (61, 62), et un réseau de transmission d'événements (2), ledit processeur de portes comprenant :
une mémoire tampon d'un nouvel événement (500c) pour mémoriser un événement à un temps de synchronisation "t" pour un élément logique prédéterminé dans une unité d'un réseau logique ;
un dispositif de sortance (500d) pour maintenir une information de connexion pour ledit élément logique prédéterminé et pour lire les données de celui-ci précédemment à un temps de synchronisation "t", les données d'entrée dudit élément logique prédéterminé étant changées à un temps de synchronisation "t+1" ;
une mémoire d'états du réseau (500f) pour maintenir des informations d'état du réseau correspondant aux données d'entrée et aux données de sortie d'un élément logique prédéterminé ; et,
un dispositif d'évaluation (500e) pouvant être mis en fonctionnement pour lire les données dans ladite mémoire d'états du réseau (500f), pour générer des informations pour un changement de l'état du réseau à un temps de synchronisation "t+1", et pour fournir lesdites informations générées au réseau de transmission d'événements (2) et/ou à ladite mémoire tampon d'un nouvel événement (500c) ;
caractérisé en ce que ladite mémoire d'états du réseau (500f) est agencée pour recevoir lesdites informations de la mémoire tampon d'un nouvel événement (500c) au début de chaque cycle de fonctionnement, et pour fournir les dites informations audit dispositif d'évaluation (500e) sans recevoir de données de celui-ci ;
et en ce qu'une mémoire tampon de portes d'évaluation (500g) est prévue qui comporte une pluralité de zones de mémoire de portes d'évaluation (500g₁, 500g₂) dont chacune peut être connectée audit dispositif de sortance (500d) ou audit dispositif d'évaluation (500e), où une donnée d'entrée d'un élément logique prédéterminé qui est changée au temps de synchronisation "t" est fournie par une des zones de mémoire de portes d'évaluation (500g₁, 500g₂) au dispositif d'évaluation (500e), alors qu'une donnée d'entrée d'un élément logique prédéterminé qui est changée au temps de synchronisation "t+1" est reçue par une autre des zones de mémoire de portes d'évaluation (500g₁, 500g₂).

2. Processeur de portes selon la revendication 1, dans lequel ladite mémoire tampon de portes d'évaluation (500g) comprend en outre un moyen d'enregistrement d'indicateur (500g₃) pouvant être mis en fonctionnement pour enregistrer un indicateur à une adresse d'une des zones de mémoire de portes d'évaluation correspondant à un élément logique prédéterminé dans laquelle des données viennent d'être mémorisées, la mémoire tampon de portes d'évaluation (500g) pouvant ainsi maintenir des informations du dispositif de sortance (500d) sans reproduire la mémorisation des données pour un élément logique prédéterminé auquel sont fournis une pluralité de signaux d'entrée changés au cours du même cycle de fonctionnement.

3. Processeur de portes selon l'une quelconque des revendications 1 et 2, dans lequel dans chaque unité du réseau logique à simuler, les éléments logiques sont classés comme des éléments "internes" n'ayant pas d'effet sur les autres unités du réseau, ou comme des éléments "à la limite" ou "internes/à la limite" ayant un effet sur au moins une autre unité du réseau, et dans lequel, quand la mémoire tampon de portes d'évaluation (500g) reçoit des informations pour un élément logique prédéterminé du dispositif de sortance (500d), si ces informations concernent un élément à la limite ou un élément interne/à la limite, ces informations sont mémorisées à partir de l'adresse maximale de la zone de mémoire des portes d'évaluation connectée, et, si les informations concernent uniquement un élément interne, elles sont mémorisées à partir de l'adresse minimale de ladite zone de mémoire connectée, la mémoire tampon de portes d'évaluation pouvant ainsi fournir des informations pour les éléments à la limite et internes/à la limite avant des informations pour un élément interne.
